(19) Europäisches Patentamt
European Patent Office
Office européen des brevets

(11) **EP 3 814 790 B1**

(12) **EUROPÄISCHE PATENTSCHRIFT**

(45) Veröffentlichungstag und Bekanntmachung des Hinweises auf die Patenterteilung:
**09.10.2024   Patentblatt 2024/41**

(21) Anmeldenummer: **19762702.9**

(22) Anmeldetag: **28.08.2019**

(51) Internationale Patentklassifikation (IPC):
**G01R 31/367** (2019.01)   **G01R 31/374** (2019.01)
**G01R 31/382** (2019.01)   **G01R 31/392** (2019.01)

(52) Gemeinsame Patentklassifikation (CPC):
**G01R 31/392; G01R 31/367; G01R 31/374; G01R 31/382**

(86) Internationale Anmeldenummer:
**PCT/AT2019/060279**

(87) Internationale Veröffentlichungsnummer:
**WO 2020/041814 (05.03.2020 Gazette 2020/10)**

(54) **VERFAHREN UND BATTERIEMANAGEMENTSYSTEM ZUM ERMITTELN EINES GESUNDHEITSZUSTANDES EINER SEKUNDÄRBATTERIE**

METHOD AND BATTERY MANAGEMENT SYSTEM FOR ASCERTAINING A STATE OF HEALTH OF A SECONDARY BATTERY

PROCÉDÉ ET SYSTÈME DE GESTION DE BATTERIE POUR DÉTERMINER UN ÉTAT DE SANTÉ D'UNE BATTERIE SECONDAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.08.2018   AT 507442018**

(43) Veröffentlichungstag der Anmeldung:
**05.05.2021   Patentblatt 2021/18**

(73) Patentinhaber: **AVL List GmbH**
**8020 Graz (AT)**

(72) Erfinder:
• **HAMETNER, Christoph**
**1020 Wien (AT)**
• **JAKUBEK, Stefan**
**1230 Wien (AT)**
• **DOHR, Markus**
**8020 Graz (AT)**

(74) Vertreter: **Patentanwälte Pinter & Weiss OG**
**Prinz-Eugen-Straße 70**
**1040 Wien (AT)**

(56) Entgegenhaltungen:
WO-A1-2014/114564   FR-A1- 3 051 916
US-A1- 2003 184 307   US-A1- 2015 120 225
US-A1- 2015 268 309   US-A1- 2017 288 414
US-A1- 2018 143 257   US-B2- 9 217 779

**Beschreibung**

Die gegenständliche Erfindung betrifft ein Verfahren zum Ermitteln eines Gesundheitszustandes einer Sekundärbatterie, wobei mit einem Beobachter eine erste Schätzung für den Gesundheitszustand gemacht wird und ein Alterungsprädiktionsmodell zur Ermittlung einer zweiten Schätzung für den Gesundheitszustand verwendet wird, wobei entweder die erste Schätzung des Gesundheitszustand oder die zweite Schätzung des Gesundheitszustandes oder die Verknüpfung der ersten und zweiten Schätzung des Gesundheitszustandes als Gesundheitszustand der Sekundärbatterie verwendet wird. Die Erfindung betrifft auch ein Batteriemanagementsystem, das den Gesundheitszustand ermittelt und zur Steuerung des Betriebs der Sekundärbatterie verwendet.

Für den Einsatz einer Sekundärbatterie (wiederaufladbare Batterie) sind der Ladezustand (State of Charge, SoC) und der Gesundheitszustand (State of Health, SoH) wichtige Parameter. Der Ladezustand gibt an, wie weit die Batterie bezogen auf eine Maximalladung geladen oder entladen ist. Der Gesundheitszustand erlaubt eine Aussage zum aktuellen Zustand oder der Güte der Batterie, beispielsweise bezogen auf einen Nennzustand, und lässt Rückschlüsse auf die Leistungsfähigkeit oder auf eine verbliebene Restlebensdauer zu. Für den SoH gibt es aber keine definierte Kenngröße. Üblicherweise wird als Kenngröße für den SoH der Innenwiderstand oder die Kapazität der Batterie, oder auch beides, herangezogen, oftmals auch bezogen auf gegebene Nennwerte der Kenngröße(n). Beide Größen werden in einem Batteriemanagementsystem (BMS) verwendet, um den Betrieb der Batterie zu steuern. Über den Ladezustand kann beispielsweise entschieden werden, wann oder wie die Batterie zu laden ist. Über den Gesundheitszustand, gegebenenfalls auch in Abhängigkeit vom Ladezustand, kann eine bestimmte Betriebsstrategie gewählt werden, um die Lebensdauer der Batterie zu verlängern, aber auch um den Betrieb selbst zu optimieren. Ein typisches Beispiel ist das BMS eines elektrischen Antriebsstranges eines Elektrofahrzeuges oder Hybridfahrzeuges, das den Betrieb der Antriebsbatterie überwacht und steuert.

Der SoC und/oder der SoH können in der Regel nicht, oder nur sehr schwer, direkt gemessen werden. Das gilt insbesondere für die Batterie im normalen Einsatz. Daher werden diese Größen im BMS oftmals aus gemessenen Größen der Batterie geschätzt, beispielsweise mittels eines regelungstechnischen Beobachters. An der Batterie werden typischerweise messbare Größen wie der Laststrom, die Ausgangsspannung, die Temperatur, Lade-/Entladezyklen, usw. messtechnisch erfasst. Ein Beobachter ermittelt dann daraus einen aktuellen Wert des SoC und/oder des SoH. Nachdem sich der Gesundheitszustand nicht so schnell ändert, wie der Ladezustand, kann auch vorgesehen sein, den SoC häufiger als den SoH zu aktualisieren.

Die WO 2014/114564 A1 beschreibt beispielsweise einen regelungstechnischen Beobachter zum Schätzen des Ladezustandes und des Gesundheitszustandes einer Sekundärbatterie. Darin wird beschrieben, wie eine Modellstruktur in Form eines linearen Modellnetzwerkes trainiert werden kann, um den Ladezustand zu schätzen. Dabei kann auch der aktuelle Gesundheitszustand in der Schätzung des Ladezustandes berücksichtig werden und der Beobachter kann ergänzt werden, um auch den Gesundheitszustand zu schätzen.

Daneben ist es bereits bekannt geworden ein Alterungsprädiktionsmodell für Sekundärbatterien zu verwenden, um eine Abschätzung der Restlebensdauer zu treffen. Ein Beispiel hierfür findet sich in der US 9,217,779 B2.

US 2018/0143257 A1 beschreibt einen Beobachter, um einen Gesundheitszustand einer Batterie auf verschiedene Weisen zu schätzen, die miteinander verknüpft werden. Darin wird auch ein Alterungsprädiktionsmodell beschrieben, um einen in der Zukunft liegenden Gesundheitszustand zu berechnen, der zur Ermittlung des Lebensendes der Batterie verwendet wird.

Die FR 3 051 916 A1 beschreibt die Verknüpfung eines Gesundheitszustandes aus einem Beobachter und aus einem Alterungsprädiktionsmodell, um einen Gesundheitszustand einer Batterie zu ermitteln.

US 2003/184307 A1, US 2017/288414 A1, US 2015/268309 A1 und US 2015/120225 A1 beschreiben weitere bekannte Verfahren zum Ermitteln eines Gesundheitszustandes einer Sekundärbatterie basierend auf mehrere Schätzungen.

Mit einem Alterungsprädiktionsmodell wird im Prinzip die zukünftige Entwicklung des Gesundheitszustandes der Batterie in Abhängigkeit von einer bestimmten zukünftigen Belastung abgeschätzt. Hierfür gibt es für verschiedene Batterietypen, beispielsweise für eine Lithium-Ionen-Batterie (Li-Ion), verschiedene Alterungsprädiktionsmodelle. Ein Alterungsprädiktionsmodell hat eine bestimmte Modellstruktur und Modellparameter, deren Werte bei der Parametrierung festgelegt werden müssen, um das Verhalten der Sekundärbatterie möglichst gut zu beschreiben. Die Parametrierung eines solchen Alterungsprädiktionsmodells für eine bestimmte Sekundärbatterie erfordert jedoch einen hohen Messaufwand, um die Abhängigkeit der Degradation (Alterung) der Sekundärbatterie von verschiedensten Einflussgrößen, wie z.B. die Anzahl der Lade-/Entladezyklen, der Einsatzzeit, der Temperatur, der Kapazitätsrate (ein Maß für die Geschwindigkeit der Entladung), des Ladezustandes (oder des Kehrwertes, der sogenannte Entladungsgrad), usw., zu identifizieren und mit dem Modell darstellen zu können. Für die Parametrierung des Alterungsprädiktionsmodells wäre eine Vielzahl von Messdaten von Nöten, um die Parameter des Modells schätzen oder festlegen zu können. Dazu können auch noch für die Parametrierung erschwerende Effekte hinzukommen, wie beispielsweise eine schnellere Degradation gegen Ende der Lebensdauer der Sekundärbatterie oder die Unterscheidung zwischen einer Degradation aufgrund der zyklischen Belastung und der kalendarischen Alterung (aufgrund der Einsatzzeit). Es wäre ein immenser Aufwand für alle verschiedenen Sekundärbatterien oder Zellen von Sekundärbatterien die Alterungsprädiktionsmodelle rein durch Messungen und Analyse der Messdaten zu ermitteln. Deshalb kommen oftmals auch sogenannte beschleunigte Alterungstests zur Anwendung. Die Ergebnisse eines solchen beschleunigten Alterungstests können aber mitunter nicht oder nicht direkt auf die deutlich langsamere Alterung im realen Betrieb der Sekundärbatterie umgelegt werden und sind daher nur bedingt anwendbar.

Es ist daher eine Aufgabe der gegenständlichen Erfindung ein Verfahren anzugeben, mit dem ein Gesundheitszustand einer Sekundärbatterie einfacher ermittelt werden kann.

Diese Aufgabe wird erfindungsgemäß dadurch gelöst, dass das Alterungsprädiktionsmodell mit der ersten Schätzung für den Gesundheitszustand parametriert wird. Auf diese Weise kann einerseits im laufenden Betrieb der Batterie ein Alterungsprädiktionsmodell für die Sekundärbatterie aus dem mit einem Beobachter geschätzten Gesundheitszustand parametriert werden. Damit ist es nicht mehr erforderlich, das Alterungsprädiktionsmodell vorab mit Messdaten aufwendig zu parametrieren. Vielmehr wird das Alterungsprädiktionsmodell im laufenden Betrieb angepasst. Andererseits können die beiden vorliegenden ersten und zweiten Schätzungen für den Gesundheitszustand auch verknüpft werden, um eine Schätzung des Gesundheitszustandes mit höherer Qualität zu erhalten. Dabei kann die Verknüpfung vorab bestimmt oder vorgegeben werden und/oder kann an die jeweilige Anwendung angepasst werden, um eine ideale Verknüpfung anzuwenden.

Für die Parametrierung werden vorzugsweise für einen bestimmten Zeitraum des Betriebs der Sekundärbatterie aus erfassten Größen der Sekundärbatterie Alterungsfaktoren bestimmt und aus den bestimmten Alterungsfaktoren und den ersten Schätzungen für den Gesundheitszustand in diesem Zeitraum Parameter des Alterungsprädiktionsmodells ermittelt werden, mit denen das Alterungsprädiktionsmodell parametriert wird. Die Alterungsfaktoren werden hierzu vorteilhafterweise aus vorhandenen Messgrößen der Sekundärbatterie, und/oder daraus abgeleiteten Größen, ermittelt.

Ganz besonders vorteilhaft ist es, die ersten Schätzungen für den Gesundheitszustand, und gegebenenfalls Alterungsfaktoren, mehrerer Sekundärbatterien zu verwendet, um das Alterungsprädiktionsmodell zu parametrieren. Auf diese Weise kann die Parametrierung auf mehr Daten gestützt werden, was die Qualität der Parametrierung verbessert. Gleichfalls können hierbei auch die verschiedenen Betriebszustände der verschiedenen Sekundärbatterien die Qualität der Parametrierung verbessern.

Der Gesundheitszustand der Sekundärbatterie lässt sich einfach als gewichtete Summe aus der ersten Schätzung des Gesundheitszustandes und der zweiten Schätzung des Gesundheitszustandes ermittelt, wobei die Gewichtung vorgegeben sein kann oder angepasst werden kann. Nachdem bei der Parametrierung in der Regel auch Unsicherheiten oder Konfidenzintervalle ermittelt werden, kann die Gewichtung vorteilhafterweise auch anhand der Unsicherheiten oder Konfidenzintervalle der ersten und zweiten Schätzung erfolgen. Ebenso kann bei der Verknüpfung auch eine Betriebscharakteristik der Sekundärbatterie berücksichtigt werden. Das gibt vielfältige Möglichkeiten zur Verknüpfung der beiden vorhandenen Schätzungen des Gesundheitszustandes. Damit kann die Ermittlung des Gesundheitszustandes auch einfach an die jeweilige Anwendung optimal angepasst werden.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt

Fig.1 eine von einem Batteriemanagementsystem gesteuerte Sekundärbatterie zur Versorgung einer elektrischen Last,
Fig.2 ein erfindungsgemäßes Batteriemanagementsystem,
Fig.3 eine Ausführung mit externer Parametrierung des Alterungsprädiktionsmodells und
Fig.4 eine Ausführung mit externer Parametrierung des Alterungsprädiktionsmodell auf Basis von Daten von verschiedenen Sekundärbatterien.

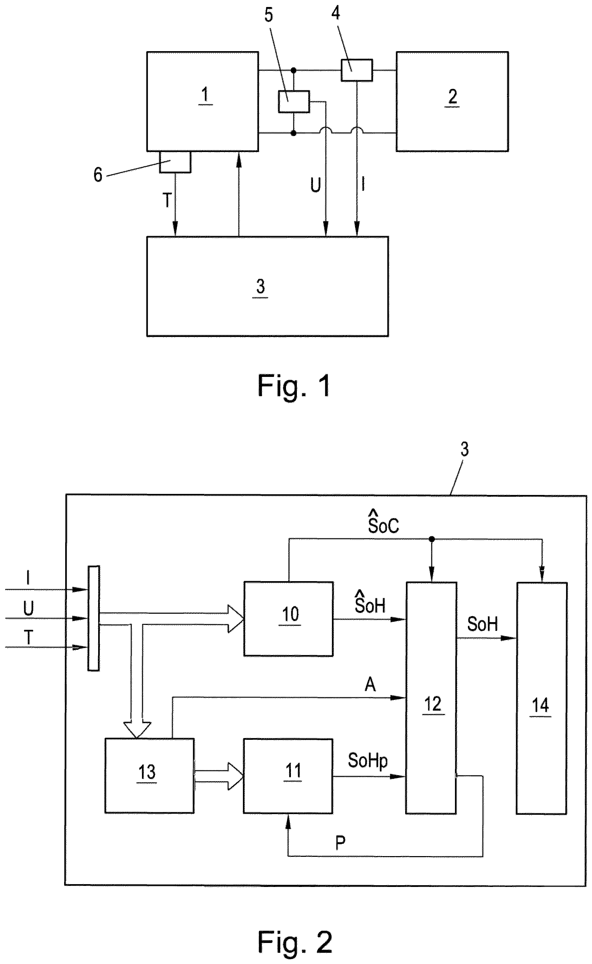

Fig.1 zeigt eine Sekundärbatterie 1, die mit einer elektrischen Last 2 verbunden ist. Die elektrische Last 2 ist beispielsweise ein elektrischer Antrieb eines Elektrofahrzeuges oder eines Hybridfahrzeuges. Die Sekundärbatterie 1 wird von einer Batteriesteuereinheit, in der Regel als Batteriemanagementsystem 3 bezeichnet, gesteuert und überwacht. Das Batteriemanagementsystem 3 steuert Maßnahmen, um die Leistungsfähigkeit und Lebensdauer der Sekundärbatterie 1 zu optimieren. Typische Funktionen des Batteriemanagementsystems 3 sind der Schutz der einzelnen Zellen der Sekundärbatterie 1, das Ausbalancieren der Batteriezellen, die Ladekontrolle, die Bestimmung des Ladezustandes SoC, die Bestimmung des Gesundheitszustandes SoH, aber auch das Speichern von Betriebsdaten auch in Form zeitlicher Verläufe. Daneben kann das Batteriemanagementsystem 3 auch mit einer Datenkommunikationsschnittstelle versehen sein, um mit anderen Steuereinheiten, beispielsweise einer Hybridantriebsstrang-Steuereinheit oder einer Fahrzeugsteuereinheit, Daten und Information austauschen zu können, aber auch um Daten über die Sekundärbatterie 1 bedarfsweise auslesen oder übertragen zu können (beispielsweise zu Wartungszwecken).

Das Batteriemanagementsystem 3 erhält dazu Messgrößen der Sekundärbatterie 1, die den Betrieb der Sekundärbatterie 1 charakterisieren, typischerweise den Laststrom I und die Ausgangsspannung U, aber auch die Temperatur T. Dazu können auch Stromsensoren 4, Spannungssensoren 5 oder Temperatursensoren 6 vorgesehen sein. Selbstverständlich können auch noch andere und/oder weitere messbare Größen der Sekundärbatterie 1 gemessen und im Batteriemanagementsystem 3 verarbeitet werden.

Mit Fig.2 wird die erfindungsgemäße Ausführung des Batteriemanagementsystems 3 (Hardware und/oder Software) näher beschrieben, um den Gesundheitszustand SoH der Sekundärbatterie 1 auf einfache Weise ermitteln zu können. Um die vorgesehenen Aufgaben ausführen zu können, sind für das Batteriemanagementsystem 3 insbesondere der Ladezustand SoC und der Gesundheitszustand SoH wichtig. Daher ist im Batteriemanagementsystem 3 beispielsweise ein Beobachter 10 implementiert, um den Ladezustand $\hat{S}oC$ und den Gesundheitszustand $\hat{S}oH$ zu schätzen, wobei mit "^" Schätzwerte des Beobachters 10 bezeichnet sind. Der Beobachter 10 ist beispielsweise wie in der WO 2014/114564 A1 beschrieben ausgeführt. Der Beobachter 10 basiert üblicherweise auf einem Modell der Sekundärbatterie 1, das das Verhalten der Sekundärbatterie 1 beschreibt.

Zusätzlich ist im Batteriemanagementsystem 3 ein Alterungsprädiktionsmodell 11 implementiert. Mit einem Alterungsprädiktionsmodell 11 kann die zukünftige Entwicklung des Gesundheitszustandes $SoH_p$ der Sekundärbatterie 1 in Abhängigkeit von einer bestimmten zukünftigen Belastung der Sekundärbatterie 1 ermittelt werden. Dazu muss das Alterungsprädiktionsmodell 11 aber parametriert werden, d.h., dass die Parameter des Alterungsprädiktionsmodells 11 bestimmt werden müssen, sodass das Verhalten der Sekundärbatterie 1 hinsichtlich der Entwicklung des Gesundheitszustandes $SoH_p$ bestmöglich beschrieben wird. Diese Parametrierung ist aber in der Regel sehr aufwendig. Um dieses Problem zu beheben, werden erfindungsgemäß die mit dem Beobachter 10 im Batteriemanagementsystems 3 bestimmten Werte für den Gesundheitszustand $\hat{S}oH$ zur Parametrierung des Alterungsprädiktionsmodells 11 verwendet, wie nachfolgend näher ausgeführt wird.

Das Alterungsprädiktionsmodell 11 kann allgemein in der Form $\Delta SoH_i = f(A_i, P)$ angeschrieben werden. Darin beschreibt $\Delta SoH_i$ die Änderung des Gesundheitszustandes SoH in einem bestimmten Zeitraum, der durch den Index i ausgedrückt wird. f beschreibt die, üblicherweise nichtlineare, Modellstruktur, beispielsweise ein Lokales Modellnetzwerk, ein Polynom Modell, Gauss-Prozess Modell, usw. mit den Parametern P. $A_i$ enthält alle Alterungsfaktoren, die im Modell berücksichtigt werden. Mögliche, bzw. häufig verwendete, Alterungsfaktoren A sind die Anzahl der Lade-/Entladezyklen, die Einsatzzeit, die Temperatur, die Kapazitätsrate (ein Maß für die Geschwindigkeit der Entladung), der Ladezustandes, der Entladungsgrad, der Gesundheitszustand und/oder ein Erwärmungskoeffizient, wobei natürlich auch weitere oder andere Alterungsfaktoren verwendet werden können. Die Alterungsfaktoren sind dabei insbesondere von der Belastung der Sekundärbatterie 1 abhängig. Der Gesundheitszustand SoH ergibt sich dann durch Aufsummieren

$$SoH = \sum_{i=1}^{n} \Delta SoH_i$$

der einzelnen Änderungen $\Delta SoH_i$ der einzelnen Zeiträume, also . Es ist offensichtlich, dass damit so-wohl ein aktueller Gesundheitszustand SoH berechnet werden kann (bis zum aktuellen Zeitraum), aber auch eine zukünftige Entwicklung des Gesundheitszustandes SoH, wenn für zukünftige Zeiträume bestimmte Belastungen angenommen werden.

Das Alterungsprädiktionsmodell 11 kann beispielsweise als Polynommodell implementiert sein, wobei als Gesundheitszustand SoH beispielsweise eine Ladungsmenge Q als Maß für die Kapazität der Sekundärbatterie 1 verwendet wird. Darin werden als Alterungsfaktoren A die Faktoren $t_i$ als aktueller Zeitschritt in einer Zeiteinheit, $Ah_i$ als Amperestunden Durchsatz im Zeitschritt $t_i$, $T_i$ als Temperatur im Zeitschritt $t_i$ (z.B. die mittlere oder maximale Temperatur) und $T_0$ als Temperatur, an der die Alterung ein Minimum erreicht (z.B. 25°C) und die Parameter $P = [p_1, p_2, p_3, p_4, p_5, p_6]$ verwendet, um das Verhalten der Alterung der Sekundärbatterie 1 zu beschreiben. Daraus wird ein Kapazitätsverlust

$\Delta Q_i$ im Zeitschritt $t_i$ nach der Formel $\Delta Q_i = p_1\sqrt{t_i} + p_2 t_i + p_3\sqrt{Ah_i} + p_4 Ah_i + p_5 t_i Ah_i + p_6\left(T_i - T_0\right)^2 Ah_i$ berechnet. Der Gesundheitszustand SoH ergibt sich dann als Kapazitätsverlust Q durch Aufsummieren über die einzelnen

Zeitschritte $t_i$, also in der Form $SoH = \sum_{i=1}^{n} \Delta Q_i$ . Natürlich könnte auch ein gesamter Ladungsverlust Q ermittelt werden und daraus auf einen anderen Parameter für den Gesundheitszustand SoH umgerechnet werden.

Der derart mit dem Alterungsprädiktionsmodell 11 ermittelte Gesundheitszustand $SoH_p$ kann eine Kapazität (auch als Ladungsmenge Q) der Sekundärbatterie 1 oder ein Innenwiderstand der Sekundärbatterie 1, oder auch beides, oder auch ein anderer Kennwert sein.

Es sei aber angemerkt, dass natürlich auch andere als die erwähnten Modellstrukturen für das Alterungsprädiktionsmodell 11 verwendet werden können. Ebenso ist es möglich, dass mit dem Modell keine Änderungen $\Delta SoH_i$ berechnet werden, die dann aufsummiert werden, sondern, dass direkt der Gesundheitszustand $SoH_p$ berechnet wird.

Für die Erfindung ist die konkrete Wahl der Modellstruktur, der Alterungsfaktoren und Implementierung des Modells letztendlich nebensächlich und kann auch vom Typ der Sekundärbatterie 1 abhängig sein.

An sich ist es auch hinlänglich bekannt, wie ein Modell mit einer bestimmten Modellstruktur und mit Parametern P zur Parametrierung trainiert werden kann, weshalb nur kurz darauf eingegangen wird. Im Wesentlichen sind hierfür bekannte Messdaten der Sekundärbatterie 1 erforderlich, also Messdaten für den Gesundheitszustand SoH und für die Alterungsfaktoren A. Ein Teil der bekannten Messdaten kann für die Parametrierung verwendet werden, wobei für verschiedene Modellstrukturen verschiedene Parametrierverfahren möglich sind. Der restliche Teil der Messdaten kann zur Validierung des parametrierten Modells herangezogen werden, also dazu zu überprüfen, wie genau das parametrierte Modell das Verhalten der Batterie annähert. In Hametner C., Jakubek S., "State of Charge estimation of Lithium Ion cells: Design of Experiments, nonlinear identification and fuzzy observer design", Journal of Power Sources 238 (2013) 413 - 421 beschreibt das beispielsweise für ein Lokales Modellnetzwerk zur Schätzung des Ladezustandes SoC einer Sekundärbatterie 1. Die WO 2014/114564 A1 beschreibt das auch mit der zusätzlichen Schätzung des Gesundheitszustandes SoH. Daneben können noch hinlänglich bekannte Parameterschätzverfahren eingesetzt werden, die einen bestimmten definierten Fehler (z.B. ein mittlerer quadratischer Fehler) durch Variation der Parameter minimieren. Solche Verfahren sind üblicherweise iterative Verfahren, wobei die Iterationen durchgeführt werden, bis ein bestimmtes Abbruchkriterium erfüllt ist, beispielsweise eine bestimmte Anzahl von Iterationen oder das Erreichen einer bestimmten Fehlergrenze. Bei der Parametrierung werden allgemein gesprochen die Parameter P so gewählt, dass die bekannten Messdaten durch das Modell bestmöglich angenähert werden. Der Rest der bekannten Messdaten kann dann zur Validierung des bestimmten Modells herangezogen werden, woraus auch Konfidenzintervalle bestimmt werden können, die eine Aussage über die Unsicherheit der Schätzung ermöglichen.

Die Parametrierung, also die Bestimmung der Parameter P, kann im einfachsten Fall direkt über eine gewöhnliche Least Squares Schätzung erfolgen. Die Parameter P des Modells können aber wiederum selbst von den Alterungsfaktoren $A_i$ abhängen. In diesem Fall können bekannte nichtlineare Verfahren, z.B. gradientenbasierte Methoden, zur Schätzung der Parameter eingesetzt werden. Zusätzlich können auch Ansatzfunktionen, z.B. eine sogenannte Hazard-Funktion zur Beschreibung der Ausfalls-/Schädigungsrate, verwendet werden, um nichtlineare Alterungsverläufe darstellen zu können, wie z.B. eine beschleunigte Alterung am Beginn und Ende der Lebensdauer. Solche Verfahren zur Parametrierung sind dem Fachmann hinlänglich bekannt, weshalb hier nicht näher darauf eingegangen werden muss.

Im Rahmen der Parametrierung werden mit den Parametrierverfahren oftmals auch Konfidenzintervalle oder Unsicherheiten der jeweiligen Schätzungen ermittelt, beispielsweise aus der Validierung des parametrierten Modells. Je genauer die Schätzung, umso kleiner ist die Unsicherheit oder umso größer ist das Konfidenzintervall.

Gemäß dem erfindungsgemäßen Verfahren liegen jedoch keine derartigen Messdaten für Parametrierung vor, sondern es werden die mit dem Beobachter 10 geschätzten Werte für den Gesundheitszustand $\hat{SoH}$, und gegebenenfalls auch andere mit dem Beobachter 10 geschätzte Werte, insbesondere für den Ladezustand $\hat{SoC}$, herangezogen. Der Beobachter 10 schätzt Werte für den Ladezustand $\hat{SoC}$ in vorgegebenen Zeitschritten, beispielsweise im Sekunden- oder Minutenbereich. Da sich der Gesundheitszustand SoH nur langsam ändert, kann dieser im Beobachter 10 in deutlich größeren Zeitschritten berechnet werden, beispielsweise im Stundenbereich. Die Schätzungen des Beobachters 10 für den Gesundheitszustand $\hat{SoH}$ werden in einer Recheneinheit 12 (Hardware und/oder Software) gesammelt. Parallel dazu erfolgt in einer Datensammeleinheit 13 (Hardware und/oder Software) die Ermittlung von Alterungsfaktoren A aus dem Betrieb der Sekundärbatterie 1. Die Datensammeleinheit 13 kann aber auch Teil der Recheneinheit 12 oder auch des Alterungsprädiktionsmodells 11 sein. Beispielsweise kann aus dem Verlauf von Strom I und/oder Spannung U die Anzahl der Lade- und Entladezyklen in einem bestimmten Zeitraum i ermittelt werden. Ein Erwärmungskoeffizient kann beispielsweise proportional zum quadrierten Strom I ermittelt werden. Die Temperatur, auch als zeitlicher Verlauf, kann direkt als Messwert erhalten werden, beispielsweise von einem Temperatursensor 6. Andere Alterungsfaktoren A können auch in der Recheneinheit 12 (oder auch in der Datensammeleinheit 13) ermittelt werden, beispielsweise ein Entladungsgrad oder eine Kapazitätsrate aus den mit dem Beobachter 10 geschätzten Ladezuständen $\hat{SoC}$. Die Alterungsfaktoren A können dabei für einen bestimmten Zeitraum (Index i) ermittelt werden, oder für die gesamte Einsatzzeit der Sekundärbatterie 1. Typischerweise sind Alterungsfaktoren A kumulierte, gewichtete oder gemittelte Größen bestimmter Messgrößen.

Mit den mit dem Beobachter 10 geschätzten Werten für den Gesundheitszustand $\hat{SoH}$ und mit den parallel dazu ermittelten Alterungsfaktoren A liegen in der Recheneinheit 12 aber wiederum "Messdaten" vor, die für die Parametrierung des Alterungsprädiktionsmodells 11 verwendet werden können. Zu bestimmten Zeitpunkten werden die Parameter P des Alterungsprädiktionsmodells 11 anhand der neu hinzugekommen, und gegebenenfalls schon bekannten, "Messdaten" aktualisiert. Das bedeutet, dass die Parametrierung mit dem vorgesehenen Parametrierverfahren mit den ergänzten Messdaten wiederholt wird. Zu Beginn kann das Alterungsprädiktionsmodell 11 anhand von Erfahrungswerten oder mit bekannten Daten aus ähnlichen Batterien parametrisiert werden. Während des Betriebes der Sekundärbatterie 1 wird das Alterungsprädiktionsmodell 11 laufend anhand von tatsächlichen Daten der Sekundärbatterie 1 aktualisiert, sodass das Alterungsprädiktionsmodell 11 praktisch während des Betriebes der Sekundärbatterie 1 trainiert wird.



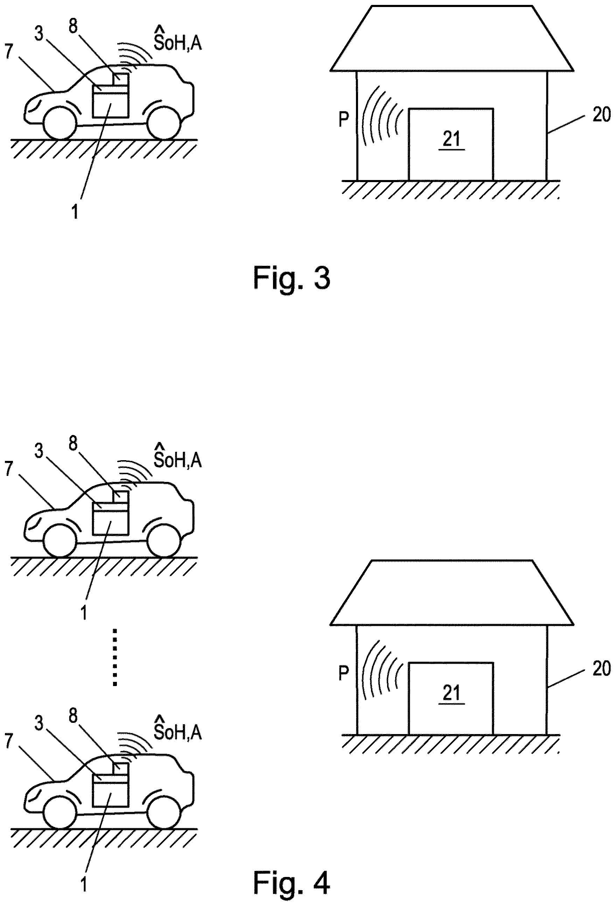

Die Parametrierung des Alterungsprädiktionsmodells 11 muss aber nicht zwingend online erfolgen und auch nicht im Batteriemanagementsystem 3, wie anhand der Fig.3 erläutert wird. Die mit dem Beobachter 10 geschätzten Werte für den Gesundheitszustand $\hat{S}oH$ und die ermittelten Alterungsfaktoren A können auch an eine Zentrale 20 gesendet werden, in der eine Recheneinheit 21 vorgesehen ist, in der die Parameter P wie beschrieben ermittelt werden. Die Parameter P werden dann in bestimmten Zeitabständen an das Batteriemanagementsystem 3 zurückgesendet und das Alterungsprädiktionsmodell 11 im Batteriemanagementsystem 3 damit aktualisiert. Dazu kann am Batteriemanagementsystem 3 auch eine Datenkommunikationseinheit 8 vorgesehen sein, um die benötigten Daten zu senden und zu empfangen. Es kann aber zu diesem Zweck auch eine Datenkommunikationseinheit 8 der Vorrichtung, in der die Sekundärbatterie 1 und das Batteriemanagementsystem 3 eingesetzt werden, beispielsweise ein Fahrzeug 7 wie in Fig.3, verwendet werden.

Auf diese Weise können die Daten aus mehreren Sekundärbatterien 1 vom gleichen Typ an die Zentrale 20 und die Recheneinheit 21 gesendet werden und zur Parametrierung des Alterungsprädiktionsmodells 11 verwendet werden, wie in Fig.4 dargestellt. Die Parametrierung des Alterungsprädiktionsmodells 11 kann verbessert werden, wenn mehr Daten über die Sekundärbatterie 1 vorhanden sind, was auf diese Weise erreicht werden kann. Das ist beispielsweise bei Hybridfahrzeugen oder Elektrofahrzeugen interessant, die mit gleichen Sekundärbatterien 1 ausgestattet sind.

Verschiedene Batteriemanagementsysteme 3 von Sekundärbatterien 1 des gleichen Typs können aber in analoger Weise auch untereinander Daten austauschen, um mehr Daten für die Parametrierung des Alterungsprädiktionsmodells 11 zu erhalten.

Das Alterungsprädiktionsmodell 11 kann aber auch dazu verwendet werden, um zu bestimmten Zeitpunkten eine Schätzung für den Gesundheitszustand $SoH_p$ der Sekundärbatterie 1 zu erhalten. Beispielsweise werden Alterungsfaktoren $A_i$ seit der letzten Aktualisierung des Alterungsprädiktionsmodells 11 gesammelt und daraus eine Änderung $\Delta SoH_i$ des Gesundheitszustand SoH in diesem Zeitraum seit der letzten Aktualisierung berechnet. Durch Aufsummieren wie oben beschrieben erhält man dann eine Modellvorhersage für den aktuellen Gesundheitszustand $SoH_p$ basierend auf dem zuletzt betrachteten Zeitpunkt (Index i-1). Damit erhält man für den aktuellen Zeitpunkt zwei Schätzungen für den Gesundheitszustand SoH, einmal den Gesundheitszustand $\hat{S}oH$ aus dem Beobachter 10 und einmal den Gesundheitszustand $SoH_p$ aus dem Alterungsprädiktionsmodell 11. Diese beiden Schätzungen können nun auch verknüpft werden, beispielsweise in der Recheneinheit 12 wie in Fig.2, um einen Gesundheitszustand SoH mit hoher Qualität der Schätzung zu erhalten, also SoH = f ($\hat{S}oH$, $SoH_p$), wobei f die Verknüpfung beschreibt. Dieser Gesundheitszustand SoH kann dann im Batteriemanagementsystem 3, beispielsweise in einer Steuereinheit 14 (Hardware und/oder Software) zur Überwachung und Steuerung der Funktion der Sekundärbatterie 1 verwendet werden.

Die Verknüpfung f der beiden Schätzungen für den Gesundheitszustand SoH , $SoH_p$ kann dabei auf verschiedenste Weise erfolgen. Beispielsweise könnte einfach ein Mittelwert der beiden Schätzungen gebildet werden. Ebenso wäre es denkbar aus den beiden Schätzungen eine gewichtete Summe zu bilden, wobei die Gewichtungsfaktoren z.B. auf die Konfidenzintervalle oder Unsicherheiten der jeweiligen Schätzungen bezogen sein können. Damit könnte eine Schätzung mit kleiner Unsicherheit höher gewichtet werden, als eine Schätzung mit höherer Unsicherheit. Es könnten aber auch Informationen aus dem Betrieb der Sekundärbatterie 1 herangezogen werden, um Entscheidungen zu treffen, welche der Schätzungen verwendet wird oder wie diese verknüpft werden. Beispielsweise kann bei einer Betriebscharakteristik mit geringer Anregung der Sekundärbatterie 1, beispielsweise bei einer vornehmlich kalendarischen Alterung, der Schätzung des Gesundheitszustandes $SoH_p$ mit dem Alterungsprädiktionsmodell 11 mehr vertraut werden, als der Schätzung des Gesundheitszustand $\hat{S}oH$ mit dem Beobachter 10. Damit kann die Schätzung mit dem Alterungsprädiktionsmodell 11 höher gewichtet werden oder nur die Schätzung des Alterungsprädiktionsmodells 11 herangezogen werden. Umgekehrt kann bei Betriebscharakteristik mit ausreichender Anregung der Sekundärbatterie 1, beispielsweise bei einem ausreichenden Fahrbetrieb eines Hybrid- oder Elektrofahrzeuges, der Schätzung durch den Beobachter 10 mehr vertraut werden. Damit kann die Schätzung mit dem Beobachter 10 höher gewichtet werden oder nur die Schätzung des Beobachters 10 herangezogen werden. Es ist offensichtlich, dass es hierbei noch viele weitere Möglichkeiten zur Verknüpfung der beiden Schätzungen des Gesundheitszustand $SoH_p$, $\hat{S}oH$ geben kann, um eine qualitativ höherwertige Schätzung des Gesundheitszustandes SoH zu erhalten.

Ebenso kann vorgesehen sein, das Alterungsprädiktionsmodell 11 nur dann zu aktualisieren, wenn den Schätzungen mit dem Beobachter 10 ausreichend vertraut werden kann. Bei geringer Anregung der Sekundärbatterie 1 (z.B. hauptsächlich kalendarische Alterung) kann eine Aktualisierung beispielsweise unterlassen werden, während bei einer ausreichenden Anregung die Aktualisierung zu festgelegten Zeitpunkten erfolgen kann.

**Patentansprüche**

1. Verfahren zum Ermitteln eines Gesundheitszustandes (SoH) einer Sekundärbatterie (1), wobei mit einem Beobachter (10) eine erste Schätzung für den Gesundheitszustand ( $\hat{S}oH$) gemacht wird und ein Alterungsprädiktionsmodell (11) zur Ermittlung einer zweiten Schätzung für den Gesundheitszustand ($SoH_p$) verwendet wird, wobei

entweder die erste Schätzung des Gesundheitszustandes (SoH) als zu ermittelnder Gesundheitszustand (SoH) der Sekundärbatterie (1) verwendet wird oder die zweite Schätzung des Gesundheitszustandes (SoH$_p$) als zu ermittelnder Gesundheitszustand (SoH) der Sekundärbatterie (1) verwendet wird oder die erste Schätzung des Gesundheitszustandes (SoH) und die zweite Schätzung des Gesundheitszustandes (SoH$_p$) verknüpft werden und die Verknüpfung der ersten und zweiten Schätzung des Gesundheitszustandes als zu ermittelnder Gesundheitszustand (SoH) der Sekundärbatterie (1) verwendet wird, **dadurch gekennzeichnet, dass** das Alterungsprädiktionsmodell (11) anhand der ersten Schätzung für den Gesundheitszustand ($\hat{S}oH$) parametriert wird.

2. Verfahren nach Anspruch 1, **dadurch gekennzeichnet, dass** für einen bestimmten Zeitraum des Betriebs der Sekundärbatterie (1) aus erfassten Größen der Sekundärbatterie (1) Alterungsfaktoren (A) bestimmt werden und aus den bestimmten Alterungsfaktoren (A) und den ersten Schätzungen für den Gesundheitszustand (SoH) in diesem Zeitraum Parameter (P) des Alterungsprädiktionsmodells (11) ermittelt werden, mit denen das Alterungsprädiktionsmodell (11) parametriert wird.

3. Verfahren nach Anspruch 1 oder 2, **dadurch gekennzeichnet, dass** erste Schätzungen für den Gesundheitszustand ($\hat{S}oH$), und gegebenenfalls Alterungsfaktoren (A), mehrerer Sekundärbatterien (1) verwendet werden, um das Alterungsprädiktionsmodell (11) zu parametrieren.

4. Verfahren nach Anspruch 1, **dadurch gekennzeichnet, dass** der Gesundheitszustand (SoH) als gewichtete Summe aus der ersten Schätzung für den Gesundheitszustand (SoH) und der zweiten Schätzung für den Gesundheitszustand (SoH$_p$) ermittelt wird.

5. Verfahren nach Anspruch 4, **dadurch gekennzeichnet, dass** die Gewichtung anhand von Unsicherheiten oder von Konfidenzintervallen der ersten und zweiten Schätzung und/oder anhand einer Betriebscharakteristik der Sekundärbatterie (1) erfolgt.

6. Verwendung des nach dem Verfahren nach einem der Ansprüche 1 bis 5 für eine Sekundärbatterie (1) ermittelten Gesundheitszustandes (SoH) in einem Batteriemanagementsystem (3) zur Steuerung des Betriebs der Sekundärbatterie (1).

7. Batteriemanagementsystem zur Steuerung des Betriebs einer Sekundärbatterie (1), wobei das Batteriemanagementsystem (3) eine Recheneinheit (12) aufweist, und wobei das Batteriemanagementsystem (3) einen Beobachter (10) aufweist, der dazu eingerichtet ist eine erste Schätzung eines Gesundheitszustandes (SoH) der Sekundärbatterie (1) zu ermitteln, und das Batteriemanagementsystem (3) ein Alterungsprädiktionsmodell (11) zur Ermittlung einer zweiten Schätzung für den Gesundheitszustand (SoH$_p$) aufweist, und wobei das Batteriemanagementsystem (3) eingerichtet ist, die Steuerung des Betriebs der Sekundärbatterie (1) entweder mit der ersten Schätzung des Gesundheitszustandes (SoH) oder der zweiten Schätzung des Gesundheitszustandes (SoH$_p$) durchzuführen oder wobei die Recheneinheit (12) dazu eingerichtet ist, die erste Schätzung des Gesundheitszustandes ($\hat{S}oH$) mit der zweiten Schätzung des Gesundheitszustandes (SoH$_p$) zu verknüpfen, wobei das Batteriemanagementsystem (3) eingerichtet ist, die Steuerung des Betriebs der Sekundärbatterie (1) mit der ermittelten Verknüpfung der ersten und zweiten Schätzung des Gesundheitszustandes als Gesundheitszustand (SoH) der Sekundärbatterie (1) durchzuführen, **dadurch gekennzeichnet, dass** die Recheneinheit (12) dazu eingerichtet ist, das Alterungsprädiktionsmodell (11) anhand der ersten Schätzung für den Gesundheitszustand ($\hat{S}oH$) zu parametrieren.

8. Batteriemanagementsystem nach Anspruch 7, **dadurch gekennzeichnet, dass** im Batteriemanagementsystem (3) eine Datensammeleinheit (13) vorgesehen ist, die dazu eingerichtet ist, aus Messgrößen (I, U, T) des Betriebs der Sekundärbatterie (1) Alterungsfaktoren (A) zu ermittelen und die Recheneinheit (12) dazu eingerichtet ist, das Alterungsprädiktionsmodell (11) anhand der ersten Schätzung für den Gesundheitszustand (SoH) und den ermittelten Alterungsfaktoren (A) zu parametrieren.

**Claims**

1. Method for ascertaining a state of health (SoH) of a secondary battery (1), in which a first estimation for the state of health ($\hat{S}oH$) is made by an observer (10) and an aging prediction model (11) is used to ascertain a second estimation for the state of health (SoH$_p$), wherein either the first estimation of the state of health ($\hat{S}oH$) or the second estimation of the state of health (SoH$_p$) is used as the state of health (SoH) of the secondary battery (1) or the first estimation of the state of health ($\hat{S}oH$) and the second estimation of the state of health (SoH$_p$) are combined and

the combination of the first and second estimation of the state of health is used as the state of health (SoH) of the secondary battery (1), **characterized in that** the aging prediction model (11) is parameterized on the basis of the first estimation for the state of health ($\hat{\text{S}}$oH).

2. Method according to claim 1, **characterized in that** aging factors (A) are determined for a certain period of operation of the secondary battery (1) from detected variables of the secondary battery (1), and parameters (P) of the aging prediction model (11) are ascertained from the determined aging factors (A) and the first estimations for the state of health ($\hat{\text{S}}$oH) in this period, by means of which parameters the aging prediction model (11) is parameterized.

3. Method according to either claim 1 or claim 2, **characterized in that** first estimations for the state of health ($\hat{\text{S}}$oH), and, optionally, aging factors (A), of a plurality of secondary batteries (1) are used to parameterize the aging prediction model (11).

4. Method according to claim 1, **characterized in that** the state of health (SoH) is ascertained as a weighted sum of the first estimation for the state of health ($\hat{\text{S}}$oH) and the second estimation for the state of health (SoH$_p$).

5. Method according to claim 4, **characterized in that** the weighting takes place on the basis of uncertainties or confidence intervals of the first and second estimation and/or on the basis of an operating characteristic of the secondary battery (1).

6. Use of the state of health (SoH) ascertained in accordance with the method according to one of claims 1 to 5 for a secondary battery (1) in a battery management system (3) for controlling the operation of the secondary battery (1).

7. Battery management system for controlling the operation of a secondary battery (1), wherein a computing unit (12) is implemented in the battery management system (3), and wherein an observer (10) which is designed to ascertain a first estimation of a state of health ($\hat{\text{S}}$oH) of the secondary battery (1) is implemented in the battery management system (3), and an aging prediction model (11) for ascertaining a second estimation for the state of health (SoH$_p$) is implemented in the battery management system (3), and wherein the battery management system (3) is designed to control the operation of the secondary battery (1) using either the first estimation of the state of health ($\hat{\text{S}}$oH) or the second estimation of the state of health (SoH$_p$) or wherein the computing (12) is designed to combine the first estimate of the state of health ($\hat{\text{S}}$oH) with the second estimate of the state of health (SoH$_p$), and in that the battery management system (3) is designed to control the operation of the secondary battery (1) using the combination of the first and second estimation of the state of health ascertained as the state of health (SoH) of the secondary battery (1), **characterized in that** the computing unit (12) is designed to parameterize the aging prediction model (11) on the basis of the first estimation for the state of health ($\hat{\text{S}}$oH).

8. Battery management system according to claim 7, **characterized in that** a data collection unit (13) is provided in the battery management system (3), which data collection unit (13) ascertains aging factors (A) from measured variables (I, U, T) of the operation of the secondary battery (1), and the computing unit (12) is designed to parameterize the aging prediction model (11) on the basis of the first estimation for the state of health ($\hat{\text{S}}$oH) and the ascertained aging factors (A).

**Revendications**

1. Procédé destiné à déterminer un état de santé (SoH) d'une batterie rechargeable (1), dans lequel une première estimation de l'état de santé (SoH) est faite à l'aide d'un observateur (10) et un modèle de prédiction de vieillissement (11) est utilisé pour la détermination d'une deuxième estimation de l'état de santé (SoH$_p$), dans lequel soit la première estimation de l'état de santé (SoH) est utilisée comme état de santé (SoH) à déterminer de la batterie rechargeable (1), soit la deuxième estimation de l'état de santé (SoH$_p$) est utilisée comme état de santé (SoH) à déterminer de la batterie rechargeable (1), soit la première estimation de l'état de santé (SoH) et la deuxième estimation de l'état de santé (SoH$_p$) sont combinées et la combinaison de la première et de la deuxième estimation de l'état de santé est utilisée comme état de santé (SoH) à déterminer de la batterie rechargeable (1), **caractérisé en ce que** le modèle de prédiction de vieillissement (11) est paramétré sur la base de la première estimation de l'état de santé (SoH).

2. Procédé selon la revendication 1, **caractérisé en ce que,** pour une période déterminée du fonctionnement de la batterie rechargeable (1), des facteurs de vieillissement (A) sont déterminés à partir de grandeurs détectées de la batterie rechargeable (1) et, à partir des facteurs de vieillissement (A) déterminés et des premières estimations de l'état de santé (SoH) dans cette période, des paramètres (P) du modèle de prédiction de vieillissement (11) sont déterminés, à l'aide desquels le modèle de prédiction de vieillissement (11) est paramétré.

3. Procédé selon la revendication 1 ou 2, **caractérisé en ce que** des premières estimations de l'état de santé (SoH) et éventuellement des facteurs de vieillissement (A) de plusieurs batteries rechargeables (1) sont utilisés pour paramétrer le modèle de prédiction de vieillissement (11).

4. Procédé selon la revendication 1, **caractérisé en ce que** l'état de santé (SoH) est déterminé comme la somme pondérée de la première estimation de l'état de santé (SoH) et de la deuxième estimation de l'état de santé (SoH$_p$).

5. Procédé selon la revendication 4, **caractérisé en ce que** la pondération a lieu sur la base d'incertitudes ou d'intervalles de confiance de la première et de la deuxième estimation et/ou sur la base d'une caractéristique de fonctionnement de la batterie rechargeable (1).

6. Utilisation de l'état de santé (SoH) déterminé pour une batterie rechargeable (1) par le procédé selon l'une des revendications 1 à 5 dans un système de gestion de batterie (3) permettant de commander le fonctionnement de la batterie rechargeable (1).

7. Système de gestion de batterie permettant de commander le fonctionnement d'une batterie rechargeable (1), dans lequel le système de gestion de batterie (3) présente une unité de calcul (12) et dans lequel le système de gestion de batterie (3) présente un observateur (10) qui est conçu pour déterminer une première estimation d'un état de santé (SoH) de la batterie rechargeable (1) et le système de gestion de batterie (3) présente un modèle de prédiction de vieillissement (11) pour la détermination d'une deuxième estimation de l'état de santé (SoH$_p$) et dans lequel le système de gestion de batterie (3) est conçu pour effectuer la commande du fonctionnement de la batterie rechargeable (1) à l'aide soit de la première estimation de l'état de santé (SoH), soit de la deuxième estimation de l'état de santé (SoH$_p$) ou dans lequel l'unité de calcul (12) est conçue pour combiner la première estimation de l'état de santé (SoH) avec la deuxième estimation de l'état de santé (SoH$_p$), le système de gestion de batterie (3) étant conçu pour effectuer la commande du fonctionnement de la batterie rechargeable (1) à l'aide de la combinaison déterminée de la première et de la deuxième estimation de l'état de santé en tant qu'état de santé (SoH) de la batterie rechargeable (1), **caractérisé en ce que** l'unité de calcul (12) est conçue pour paramétrer le modèle de prédiction de vieillissement (11) sur la base de la première estimation de l'état de santé (SoH).

8. Système de gestion de batterie selon la revendication 7,
**caractérisé en ce qu'**une unité de collecte de données (13) est prévue dans le système de gestion de batterie (3), laquelle unité est conçue pour déterminer des facteurs de vieillissement (A) à partir de grandeurs de mesure (I, U, T) du fonctionnement de la batterie rechargeable (1) et l'unité de calcul (12) est conçue pour paramétrer le modèle de prédiction de vieillissement (11) sur la base de la première estimation de l'état de santé (SoH) et des facteurs de vieillissement (A) déterminés.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014114564 A1
- US 9217779 B2
- US 20180143257 A1
- FR 3051916 A1
- US 2003184307 A1
- US 2017288414 A1
- US 2015268309 A1
- US 2015120225 A1

**In der Beschreibung aufgeführte Nicht-Patentliteratur**

- **HAMETNER C. ; JAKUBEK S.** State of Charge estimation of Lithium Ion cells: Design of Experiments, nonlinear identification and fuzzy observer design. *Journal of Power Sources,* 2013, vol. 238, 413-421